Europäisches Patentamt

(19) European Patent Office

Office européen des brevets

(11) Publication number : **0 418 498 B1**

(12) **EUROPEAN PATENT SPECIFICATION**

(45) Date of publication of patent specification :
29.12.93 Bulletin 93/52

(51) Int. Cl.[5] : **G01R 23/00,** G06F 15/36,
G06F 15/20

(21) Application number : **90113952.7**

(22) Date of filing : **20.07.90**

(54) **Block averaging of time varying signal attribute measurements.**

(30) Priority : **19.09.89 US 409471**

(43) Date of publication of application :
**27.03.91 Bulletin 91/13**

(45) Publication of the grant of the patent :
**29.12.93 Bulletin 93/52**

(84) Designated Contracting States :
**DE FR GB**

(56) References cited :
**DE-A- 3 421 728**
**US-A- 4 786 861**
**HEWLETT-PACKARD JOURNAL. vol. 40, no. 1,
February 1989, PALO ALTO US pages 35 - 41;
Paul Stephenson: "Frequency and Time Inter-
val Analyzer Measurement Hardware"**
**IEEE SPECTRUM. vol. 25, no. 7, July 1988,
NEW YORK US pages 28 - 32; David Chu:
"Phase digitizing sharpens timing
measurements"**

(73) Proprietor : **Hewlett-Packard Company
Mail Stop 20 B-O, 3000 Hanover Street
Palo Alto, California 94304 (US)**

(72) Inventor : **Nichols, Douglas C.
1349 Wylie Way
San Jose, CA 95130 (US)**
Inventor : **Stephson, Paul S.
5247 Forrest Drive
Pleasanton, CA 94566 (US)**
Inventor : **Schmitz, John S.
942 Chelin Drive
Sunnyvale, CA 94087 (US)**

(74) Representative : **Liesegang, Roland, Dr.-Ing. et
al
FORRESTER & BOEHMERT
Franz-Joseph-Strasse 38
D-80801 München (DE)**

## Description

### Field of the Invention

The invention relates generally to averaging signal attribute measurement data, and in particular to time averaging attribute measurement data of time varying signals. One application of the invention is to accurately average frequency versus time measurements for a signal with dynamic frequency.

### Background of the Invention

Averaging is a well known way to reduce the effect of noise on signal measurements. Averaging is a technique that can be used to reduce the impact of an unstable or random-like process that is present on an otherwise stable process. Averaging reveals the stable portion of the process by diminishing the contribution of the unstable process as the average progresses. The technique has little, if any, use when the entire process is unstable. For example, a frequency counter might average a number of measurements on a constant frequency signal to improve the resolution of the measurement.

To analyze the behavior of a signal over a period of time, a block of time-related measurements is taken. A display of amplitude measurements versus time will produce a waveform of the signal's behavior. For repetitive signals block averaging the corresponding samples from successive measurement blocks will improve the resolution of the measurement. Amplitude block averaging methods are found on some digitizing oscilloscopes (DSO). The general approach to averaging signal amplitude versus time requires triggering each waveform block from a reference signal. If this reference provides an unambiguous voltage that identifies a time with respect to which the amplitude characteristics of the measured signal are repeating, then block averaging can be used to obtain improved amplitude resolution.

This type of averaging is essentially one-dimensional: the y-axis values (voltage amplitude) of each update are averaged, but the x-axis values (time position) remain constant.

Continuous time interval measurements on a signal provide a way to analyze characteristics of the signal in the modulation domain, i.e., the behavior of the frequency or phase of the signal versus time. This is different than classic ways of measuring and displaying data about signals. An oscilloscope shows amplitude versus time: the time domain. A spectrum analyzer shows amplitude versus frequency: the frequency domain.

Continuous time interval measurements make it simpler to study dynamic frequency behavior of a signal: frequency drift over time of an oscillator, the frequency hopping performance of an agile transmitter, chirp linearity and phase switching in radar systems.

An example of an instrument that generates this type of time stamp and continuous time interval data is described in "Frequency and Time Interval Analyzer Measurement Hardware", Paul S. Stephenson, Hewlett-Packard Journal, Vol. 40, No. 1, February, 1989.

Block averaging is important for analyzing dynamic, repeating inputs, that are changing with time but eventually repeat in such a way that there is a stimulus to synchronize with the repetition. VCO testing provides an example of this class of input. The applied voltage tuning step provides the synchronization that allows the method of the invention to repetitively capture the frequency response.

However, the input may not be phase-coherent with respect to the synchronizing stimulus. Stated simply, phase-coherence means that the measured input would be at the same phase every time the stimulus is applied. For the VCO example, if the VCO output was always at 90 degrees (maximum high voltage) when the tuning step was applied, it would be phase-coherent. Notice that phase-coherence has nothing to do with the repeatability of the frequency at a given time. The VCO might have an arbitrary phase when the tuning step is applied, but it might also always be at 52.35 MHz at the time of the step.

The lack of phase coherence introduces time variabilities in continuous time interval measurements that conventional block averaging methods have not been able to handle.

### Summary of the Invention

The invention is a method for block averaging data from dynamic, repeating input signals, for example frequency modulated signals, taking into account the time variability of the measurement sampling. Each block of data is referenced to a synchronizing stimulus, and measurements are averaged both on the time axis and on the modulation axis. On the time axis, the time alignment for each individual measurement is placed at the center of the time interval during which the measurement was made.

For each block of data acquired, the measurement blocks are averaged together in both dimensions, time (x-axis) and modulation (y-axis result being computed), using a stimulus synchronizing signal provided by the user as a time reference (time=0). The stimulus synchronizing signal should be a stable reference with respect to the modulation function being measured. For example, if frequency vs. time is being measured, the reference should identify a repeating frequency reference. The times from the stimulus synchronizing reference to the input signal events are measured and accounted for in the averaging method of the invention.

In addition, time-alignment for each individual measurement is placed in the center of the interval being measured. With each block update, these centered times are averaged together.

Thus, the averaging method of the invention is two-dimensional, accounting for both y-axis changes (modulation axis) and x-axis changes (time axis), when averaging derived modulation parameters. Therefore the method correctly averages repetitive signals that lack phase coherence, and provides improved resolution of frequency, period, time interval and phase vs. time measurements.

Description of the Drawings

Figure 1 shows an example of sampling on a signal with linear frequency modulation.

Figure 2 shows two possible occurrences of the linear frequency modulation signal of Figure 1, with varying starting phase.

Figure 3 is a frequency versus time plot showing the result of using various averaging methods on continuous time interval data from a signal with linear frequency modulation.

Figure 4 shows the same signal occurrences shown in Figure 2, but time-aligned by the first zero-crossing.

Figure 5 illustrates the effect of time placement error for a linearly modulated input signal.

Figure 6 shows a signal with sinusoidal frequency modulation and the result of acquiring multiple time interval data block updates of this signal.

Detailed description of the Invention

With block averaging, the corresponding samples from successive measurement blocks are averaged together, which produces a block of averaged results. The objective for block averaging is to obtain greater resolution than could be provided from an individual measurement.

The inventor had determined that it is unacceptable for many types of frequency varying signals to simply average the corresponding samples from successive blocks. In fact, there are several important issues that need to be considered and dealt with before a form of block averaging that actually does provide enhanced resolution can be realized.

One might suppose that a reasonable way to perform block averaging would be to take all the first measurements from each block and average them, take all the second measurements from each block and average them, and so on. If a frequency measurement was being performed, the result from block averaging would be the same size as each individual block, with each value being the average frequency of all measurements that appeared in the same position of each block.

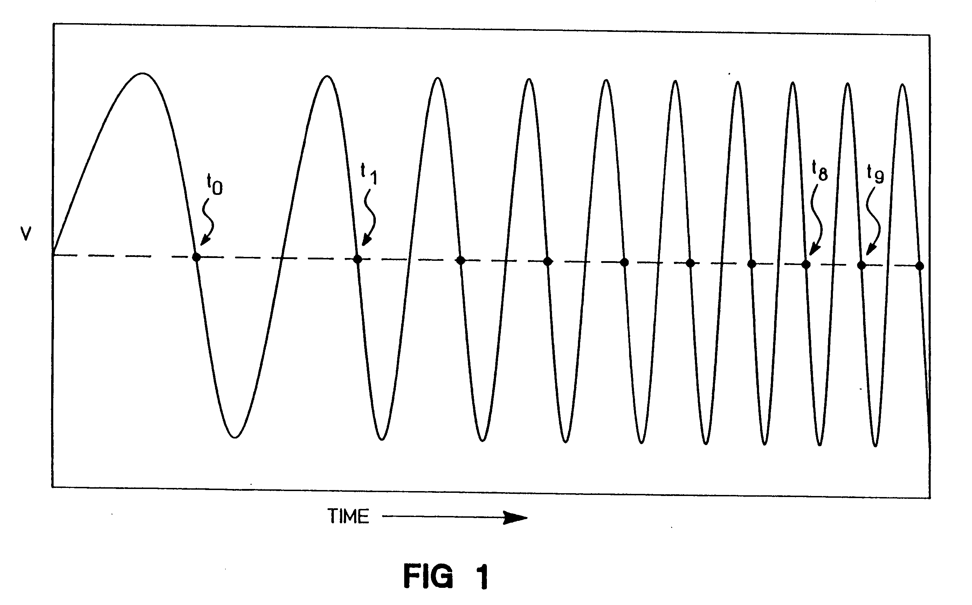

Consider using this method on a signal with linear frequency modulation, starting from an arbitrary base frequency and exhibiting arbitrary phase upon each update (phase non-coherence is the most general and probably most common situation). One occurrence of such a signal is shown in Figure 1. For all the examples discussed, a negative slope crossing will be the detected event. The crossings $t_0$, $t_1$, $t_8$ and $t_9$ are labelled in Figure 1.

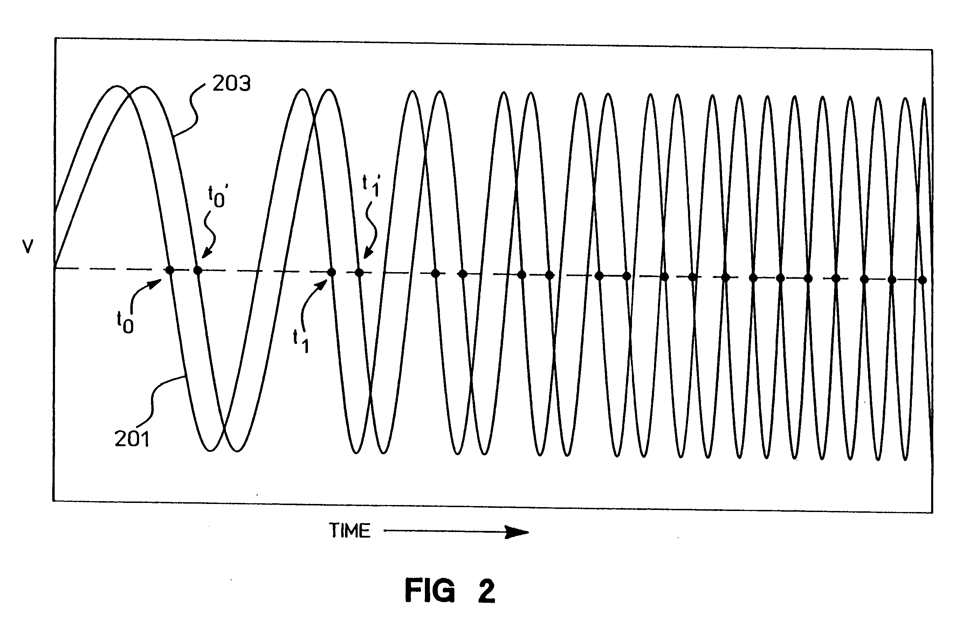

Figure 2 shows two possible occurrences of the linear frequency modulation signal, wave form 201 and wave form 203. The first two crossings for waveform 201 are labelled $t_0$, $t_1$, and the first two crossings for waveform 203 are labelled $t_0'$, $t_1'$. Because the starting phase is arbitrary, the time of the events on each wave form are different. However, the frequencies of the two wave forms are identical at all times.

Since the time alignment of the events from each waveform in Figure 2 are different, it is easy to see that combining the frequency results from each waveform, without taking into account the event timing differences, is not going to produce a useful result. To state it another way, the frequencies obtained by computing $1/(t_1 - t_0)$ for each waveform cannot be simply combined and averaged because each frequency measurement covers a different time span. Even disregarding the first event measurement of a fractional period does not help. Successive measurements of the frequency do not line up because they are made at different times and the frequency is changing over time.

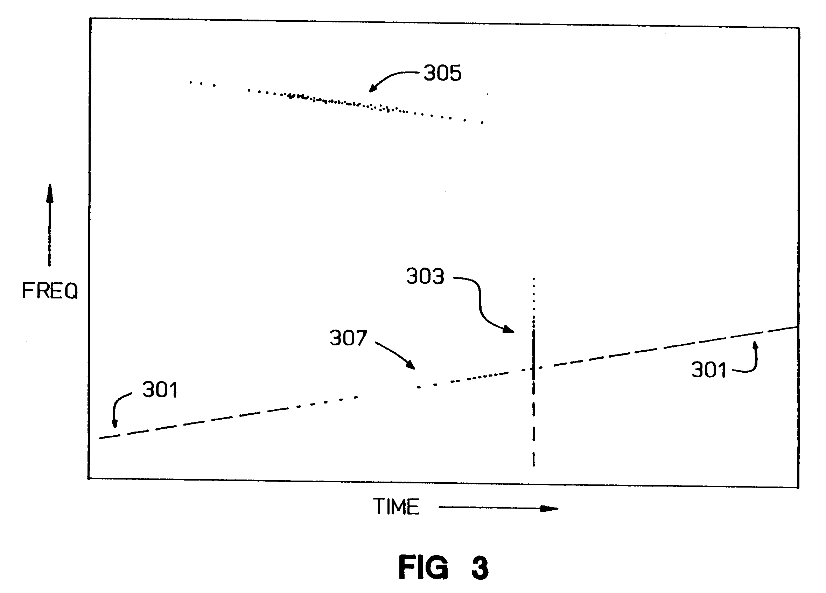

Figure 3 is a plot of frequency versus time showing the result of using various averaging methods on continuous time interval data from a signal with linear frequency modulation. The actual modulation is indicated on Figure 3 by the dashed line segments 301 appearing near the bottom left margin and slightly higher on the right margin. This line is actually continuous, but the center part has been removed to more clearly show data points 307.

The result of using a simple averaging method on a linearly modulated input is shown as data points 303 on Figure 3. The vertical line of data points 303 on Figure 3 shows the progression of the average with successive block updates. Although the order of the progression is not apparent from the figure, it is clearly undesirable that the progression is restricted to move only along a vertical line. As the number of updates progresses, the average result does not tend to converge on the line representing the actual modulation. The problem with this method is that it ignores the fact that each measurement is a frequency and a time value.

From the prior discussion, it is apparent that successive block updates must be combined using a method that considers the fact that the times of the zero-crossing events for each measurment block are different. What this amounts to is that a common time reference between the blocks must be found. What is meant by a common time reference is a time value (perhaps unique for each block) whose relationship to the frequency modulation of that block is fixed.

Another alternative might be using the first zero-crossing to define time=0. To see what would happen using the first measurement as a reference, the linear modulation example was used to test out the following averaging algorithm:

$$\hat{y} = 1/N( \sum_{k=1}^{N} y_{1,k} , \sum_{k=1}^{N} y_{2,k} , \ldots , \sum_{k=1}^{N} y_{M,k}) \tag{1}$$

$$\hat{x} = 1/N( 0, \sum_{k=1}^{N} x_{1,k} , \sum_{k=1}^{N} x_{2,k} , \ldots , \sum_{k=1}^{N} x_{M,k}) \tag{2}$$

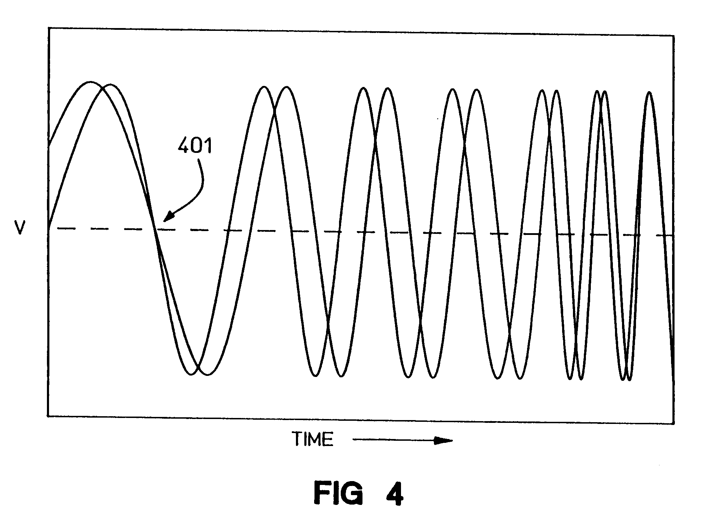

The $\hat{x}$ is used to indicate an average. M is the number of samples per block. Notice that the first value of the $\hat{x}$ result is set to 0 (the time reference) and that all other x-average values subtract off the actual measured time value of the first measurement so that they are correctly time related to this reference. Figure 4 shows the same two blocks that were shown in Figure 2. The difference is that Figure 2 showed them properly time-aligned with respect to each other (the modulation is the same on both at all times), while Figure 4 shows them time-aligned by the first zero-crossing 401, the way they would be aligned by this averaging method.

The data points 305 on Figure 3 show the result of attempting to build an average from consecutive updates using first sample time-alignment. The plot demonstrates the fundamental problem: the first sample in the block is not a meaningful time-reference to anything other than the block that it is a part of.

The method of the invention provides a new type of averaging that references the measurement block to the synchronizing stimulus, e.g., the arming edge, rather than to the first sample. This is precisely what is required to properly time relate multiple time interval data blocks of a repetitively modulated input. The arming edge must have a stable relationship to the modulation on the input.

This reference requirement allows alignment of modulation vs. time for successive blocks of data. The data points 307 in Figure 3 show the progression of averages for a single data point using the block arming reference as time=0 for each block. For example, the reference edge might be the voltage tuning step from a VCO and the measured signal the VCO output. As Figure 3 shows, all of the block updates of the average lie on the actual modulation line 301.

Using the block arming edge as the time reference (time=0) for each block that is acquired, the blocks are averaged together in both dimensions, time (x-axis) and f(t) (y-axis result being computed).

The f(t) average results are given by:

$$(1/N)\{\sum_{k=1}^{N} f(x_{1,k}) , \sum_{k=1}^{N} f(x_{2,k}) , \ldots , \sum_{k=1}^{N} f(x_{M,k})\} \tag{3}$$

where:

    N = the number of measurement blocks;

    M = the number of samples per block;

    $f(x_{i,k})$ = the measured value for the ith sample measurement in the kth block;

For the time axis, time-alignment for each individual measurement is placed such that it falls in the center of the interval being measured. With each block update, these centered times are averaged together. The time-axis average waveform is given by:

$$(1/N)\{\sum_{k=1}^{N} [(t_{1,k} + t_{2,k})/2 - ref_k], \sum_{k=1}^{N} [(t_{2,k} + t_{3,k})/2 - ref_k], \ldots, \sum_{k=1}^{N} [(t_{M,k} + t_{M+1,k})/2 - ref_k]\} \qquad (4)$$

where:

N = the number of measurement blocks;

M = the number of samples per block;

$t_{i,k}$ = the starting time stamp for the ith sample measurement in the kth block;

$t_{i+1,k}$ = the stop time stamp for the ith sample measurement in the kth block;

$ref_k$ = the time stamp for the arming edge.

In addition to averaging so that the time relationships between the blocks are properly accounted for, it is important that the time placement of the samples within the measurement block is also proper.

The time-axis averaging relationship of the invention, as shown in equation (4) above, positions the measurement at the midpoint between the start and stop time stamp for the measurement, at $(t_{1,k} + t_{2,k})/2$.

Conventionally, the position of the time of occurrence of a processed result (such as frequency or period) is set at the time of the event which initiated that particular measurement. For example, in the frequency measurement on the first interval of the waveform shown in Figure 1, the frequency value will be $1/(t_1 - t_0)$ and the time at which this frequency is said to have occurred will be $t_0$, the time of the event that initiated the measurement

In fact, placement of the measurement time at the starting event time causes two problems, the first of which is not only a problem for block averaging, but is a problem for all measurements which use a start and stop event to derive a result: the time relationships of the samples within a block are distorted; and this type of time placement, if used for a time stamp type measurement (one where the timing from the block arming edge to the first sample is measured) creates a misleading impression of when the frequency occurred (assuming it is a frequency measurement) with respect to the block arm edge.

To illustrate the problem of time distortion (which results in a distorted overall representation of the time variation result), consider again the linearly modulated signal shown in Figure 1. Because the frequency of the input signal is linearly modulated, the instantaneous frequency increases during the period from $t_0$ to $t_1$ over which the measurement is made. The measurement reflects the average frequency for that period, higher than the frequency at $t_0$. Thus, placing this measurement on the time axis at time $t_0$ will produce an incorrect result. The error committed by aligning each result at the start boundary is a function of the frequency being measured. The higher the frequency, the closer the placement is to the correct time, and hence the smaller the error.

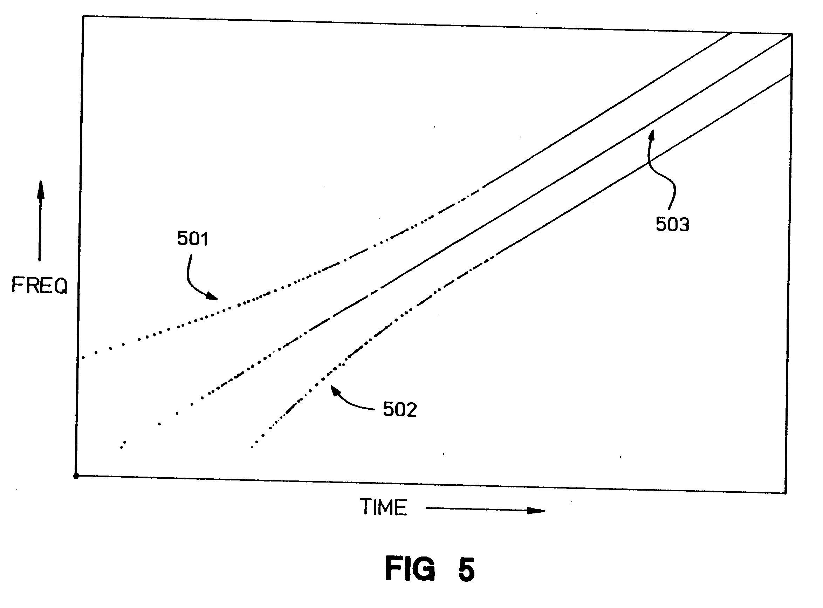

Figure 5 illustrates the effect of time placement error for a linearly modulated input signal. Each of the three plots 501, 502 and 503 represents the first several negative zero-crossings for an ideal linear frequency modulation signal. The phase is randomly varied on each block update, which allowed the time of the zero crossings to move.

The uppermost plot 501 shows the result from aligning each measurement at the start time stamp for that measurement. Both of the problems discussed earlier are evident. Although the actual modulation was linear, this result is curved. This is due to the effect of greater error at lower frequencies. As the frequency increases, the result gets closer to the actual instantaneous frequency. The upper plot 501 exhibits an offset from the actual modulation (center plot). For this increasing frequency linear modulation, the offset means that this curve claims that a given frequency was reached earlier than it actually was.

The lower plot 502 on Figure 5 shows the result if each measurement is time-aligned to the stop time stamp (rather than the start event) for that measurement. Since the average frequency for each measurement occurred prior to the alignment time, and the frequency is always increasing, the plot always underestimates the instantaneous frequency and is distorted due to greater error at the lower frequencies.

The middle plot 503 on Figure 5 shows the result of time aligning each measurement in the center of the interval $((t_i + t_{i+1})/2$. This result falls precisely upon the modulation. For nonlinear modulation, this method for time-aligning will not always be perfect, but given the fact that there is no knowledge of what the frequency is doing within the measurement interval (it is only an average frequency measurement), it is better position the measurement at the center of the measurement interval, rather than at one of the interval boundaries.

With this method the result is nearly distortion-free as long as the frequency change within the interval is near zero or no greater than first-order (linear).

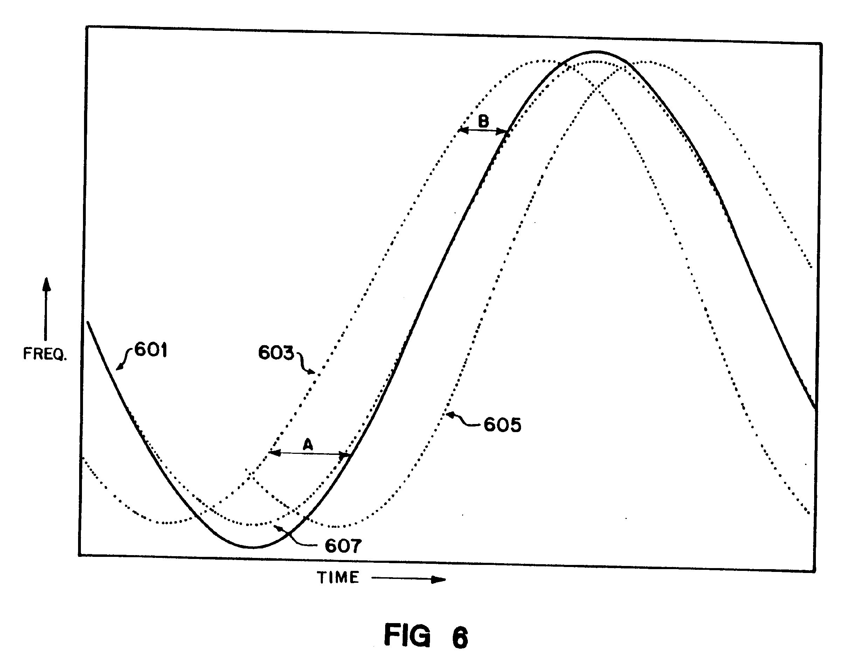

To further illustrate the operation of the averaging method of the invention, a signal with sinusoidal frequency modulation and the result of acquiring multiple time interval data block updates of this signal is shown in Figure 6. The phase of each update was allowed to randomly vary, but the frequency modulation vs. time was not, of course, allowed to vary.

The solid sinusoid 601 shown in Figure 6 represents the true instantaneous frequency. As with the linear modulation example of Figure 5, three positioning methods were used. For curve 603 the time of each measurement is positioned at the start of each sampling interval. For curve 605 the time of each measurement is positioned at the stop of each sampling interval. The offset error is obvious, but the distortion is subtle. If there was only offset error, the horizontal time to the true modulation would be constant throughout the waveform. But as indicated on Figure 6 by segments A and B, the time is greater when the frequency is lower (A is longer than B). This is distortion of the same type that was described for the linear modulation examples.

The result which falls most nearly on the true modulation is curve 607, produced by the method of the invention, time aligned to the centre of each measurement interval. Unlike the linear modulation example, this example demonstrated the limitation for nonlinear frequency modulation. The distortion has several causes. In the region where the modulation frequency goes from its lowest value to the center value, the rate of frequency change is non-linear such that it is accelerating through the sample interval. This means that an average frequency estimate of such an interval will be slightly overstated (too high) by placing the time at the center of the interval.

In the region where the modulation frequency goes from the center value to its highest value, the rate of frequency change is non-linear such that it is decelerating through the sample interval, which will result in a slightly understated (too low) frequency estimate by placing the time at the center of the interval.

At the lowest modulation frequency (the bottom of the sine wave), the average frequency value is unable to get as low as the actual modulation frequency. This is because the actual low value is an instantaneous occurrence, while the average frequency measurements occur over finite intervals. The longer the measured interval, the more the average value will tend to pull away from the instantaneous value. Since the period is longer at the lowest modulation frequency than it is at the highest modulation frequency, there is more error at the low end. This can be seen on Figure 6 where the measured frequency comes much closer to the true instantaneous frequency at the highest modulation frequency (shorter intervals) than it does at the lowest modulation frequency (longer intervals).

## Claims

1. A method for block averaging measurement data from dynamic, repeating modulated input signals, to take into account the time variability of the measurement sampling, comprising the steps of:

    making measurements of the modulation on the signal between start and stop events, referenced to a synchronizing stimulus stable with respect to the modulation function being measured, to obtain blocks of measurement data,

    relating the time axis position of the data for each block to the synchronizing stimulus to that block;

    placing the time alignment for each measurement datum at the center of the time period between the start and stop events;

    averaging the measurement data for a plurality of blocks in time;

    averaging the measurement data for a plurality of blocks in modulation;

    combining the averaged data to produce a block of averaged measurements.

2. The method of claim 1 wherein:

    the step of making measurements comprises acquiring time stamp data for the synchronizing stimulus, and for the start and stop event for each measurement.

3. The method of claim 2 wherein:

    the modulation averaging step is performed by using the relationship,

$$(1/N) \left( \sum_{k=1}^{N} f(x_{1,k}) + \sum_{k=1}^{N} f(x_{2,k}) , \ldots , \sum_{k=1}^{N} f(x_{M,k}) \right)$$

where:

    N = the number of measurement blocks;

    M = the number of samples per block;

$f(x_{i,k})$ = the measured value for the ith sample measurement in the kth block.

4. The method of claim 2 wherein:
the time averaging step is performed by using the relationship,

$$(1/N) \left\{ \sum_{k=1}^{N} [(t_{1,k} + t_{2,k})/2 - ref_k], \sum_{k=1}^{N} [(t_{2,k} + t_{3,k})/2 - ref_k], \ldots, \sum_{k=1}^{N} [(t_{M,k} + t_{M+1,k})/2 - ref_k] \right\}$$

where:
N = the number of measurement blocks;
M = the number of samples per block;
$t_{i,k}$ = the starting time stamp for the ith sample measurement in the kth block;
$t_{i+1,k}$ = the stop time stamp for the ith sample measurement in the kth block;
$ref_k$ = the time stamp for the synchronizing stimulus.

**Patentansprüche**

1. Verfahren zum blockweisen Bilden von Mittelwerten aus Meßdaten von dynamischen, sich wiederholenden modulierten Eingangssignalen, um die zeitliche Veränderlichkeit der Meßproben zu berücksichtigen, mit den Verfahrensschritten:
Durchführen von Messungen der Modulation auf dem Signal zwischen Start- und Stopp-Ereignissen, die auf ein bezüglich der zu messenden Modulationsfunktion stabiles Synchronisier-Stimulussignal bezogen sind, um Blöcke von Meßdaten zu erhalten,
in Bezug setzen der Zeitachsenposition der Daten für jeden Block zum Synchronisier-Stimulussignal für diesen Block,
Anordnen der Zeitausrichtung für jedes Meßdatum in der Mitte der Zeitspanne zwischen den Start- und Stopp-Ereignissen,
Mitteln der Meßdaten für mehrere Blöcke über der Zeit,
Mitteln der Meßdaten für mehrere Blöcke über der Modulation,
Kombinieren der gemittelten Daten, um einen Block aus gemittelten Messungen zu erzeugen.

2. Verfahren nach Anspruch 1, bei dem während dem Durchführen der Messungen Zeitstempeldaten für das Synchronisier-Stimulussignal und für das Start- und Stopp-Ereignis für jede Messung erfaßt werden.

3. Verfahren nach Anspruch 2, bei dem die Mittelung bezüglich der Modulation unter Verwendung der folgenden Beziehung durchgeführt wird:

$$(1/N) \left\{ \sum_{k=1}^{N} f(x_{1,k}), + \sum_{k=1}^{N} f(x_{2,k}), \ldots, \sum_{k=1}^{N} f(x_{M,k}) \right\}$$

wobei
N = die Anzahl der Meßblöcke,
M = die Anzahl der Abtastwerte pro Block,
$f(X_{i,k})$ = der Meßwert für die i-te Meßprobe im k-ten Block.

4. Verfahren nach Anspruch 2, bei dem die Mittelung bezüglich der Zeit unter Verwendung der folgenden Beziehung durchgeführt wird:

$$(1/N) \left\{ \sum_{k=1}^{N} [(t_{1,k} + t_{2,k})/2 - ref_k], \sum_{k=1}^{N} [(t_{2,k} + t_{3,k})/2 - ref_k], \ldots, \sum_{k=1}^{N} [(t_{M,k} + t_{M+1,k})/2 - ref_k] \right\}$$

wobei

N = die Anzahl der Meßblöcke,

M = die Anzahl der Abtastwerte pro Block,

$t_{i,k}$ = der Startzeitstempel für die i-te Meßprobe im k-ten Block,

$t_{i+1,k}$ = der Stoppzeitstempel für die i-te Meßprobe im k-ten Block,

$ref_k$ = der Zeitstempel für das Synchronisier-Stimulussignal.


## Revendications

1. Un procédé de calcul de moyenne par bloc pour des données de mesure à partir de signaux d'entrée dynamiques modulés qui se répètent afin de prendre en compte le caractère variable en fonction du temps de l'échantillonnage de mesure, comprenant les étapes consistant à

   effectuer des mesures de la modulation du signal entre des événements de début et d'arrêt, référencés à une stimulation stable de synchronisation par rapport à la fonction de modulation en cours de mesure afin d'obtenir des blocs de données de mesure,

   relier la position sur l'axe de temps de la donnée de chaque bloc à la stimulation de synchronisation de ce bloc,

   placer, pour chaque donnée de mesure, l'alignement de temps au centre du laps de temps s'écoulant entre les événements de début et d'arrêt;

   calculer une moyenne des données des mesures pour une série de blocs dans le temps;

   calculer une moyenne des données des mesures pour une série de blocs en modulation;

   combiner les moyennes de données afin de produire un bloc de moyennes de mesures.

2. Le procédé selon la revendication 1 dans lequel

   l'étape de réalisation de mesure comprend une acquisition de données d'horodateur pour la stimulation de synchronisation et pour l'événement de début et d'arrêt pour chaque mesure.

3. Le procédé selon la revendication 2 dans lequel l'étape de calcul de moyenne de modulation est effectué en utilisant la relation

$$(1/N)\{ \sum_{k=1}^{N} f(x_{1,k}) + \sum_{k=1}^{N} f(x_{2,k}), \ldots, \sum_{k=1}^{N} f(x_{i,k})\}$$

où

N = le nombre de blocs de mesures

M = le nombre d'échantillons par bloc

$f(x_{i,k})$ = la valeur mesurée pour la i-ième mesure d'échantillon du k-ième bloc.

4. Le procédé selon la revendication 2, dans lequel l'étape de calcul de moyenne de temps est effectuée en utilisant la relation

$$(1/N)\{ \sum_{k=1}^{N} [(t_{1,k}+t_{2,k})/2-ref_k], \sum_{k=1}^{N} [(t_{2,k}+t_{3,k})/2-ref_k ],\ldots,$$
$$\sum_{k=1}^{N} [(t_{M,k}+t_{M+1,k})/2-ref_k]\}$$

où

N = le nombre de blocs de mesures

M = le nombre d'échantillons par bloc

$t_{1,k}$ = l'horodateur de début de la i-ième mesure d'échantillon du k-ième bloc

$t_{1+I,k}$ = l'horodateur d'arrêt de la i-ième mesure d'échantillon du k-ième bloc

$ref_k$ = l'horodateur de la stimulation de synchronisation

FIG 1

TIME

FIG 2

EP 0 418 498 B1

FIG 3

FIG 4

**FIG 5**

EP 0 418 498 B1

FIG 6